# EUROPÄISCHE PATENTSCHRIFT

(11) **EP 1 314 191 B1**
(45) Veröffentlichungstag und Bekanntmachung des Hinweises auf die Patenterteilung: **31.03.2004**
(21) Anmeldenummer: 01974023.2
(22) Anmeldetag: 31.08.2001
(51) Int. Cl.: H01L 21/205, C23C 16/02

(54) **KOMPOSITSTRUKTUR FÜR ELEKTRONISCHE MIKROSYSTEME SOWIE VERFAHREN ZUR HERSTELLUNG DER KOMPOSITSTRUKTUR**
COMPOSITE STRUCTURE FOR ELECTRONIC MICROSYSTEMS AND METHOD FOR PRODUCTION OF SAID COMPOSITE STRUCTURE
STRUCTURE COMPOSITE POUR MICROSYSTEMES ELECTRONIQUES ET PROCEDE DE PRODUCTION DE LADITE STRUCTURE

(30) Priorität: 01.09.2000 DE 10043511
(43) Veröffentlichungstag der Anmeldung: 28.05.2003
(73) Patentinhaber: Fraunhofer-Gesellschaft zur Förderung der angewandten Forschung e.V., 80686 München (DE)
(72) Erfinder: GÜTTLER, Herbert, 89275 Elchingen (DE); KOIDL, Peter, 79211 Denzlingen (DE); SEELMANN-EGGEBERT, Matthias, 79100 Freiburg (DE)
(74) Vertreter: Gagel, Roland, Dr.
(86) Internationale Anmeldenummer: PCT/DE2001/003418
(87) Internationale Veröffentlichungsnummer: WO 2002/019403

(56) Entgegenhaltungen:
- EP-A- 0 681 314
- EP-A- 0 681 336
- DE-A- 19 718 618
- FR-A- 2 734 663
- US-A- 5 767 578
- US-A- 5 837 322
- RAMESHAM R: "SELECTIVE GROWTH AND CHARACTERIZATION OF DOPED POLYCRYSTALLINE DIAMOND THIN FILMS" THIN SOLID FILMS, ELSEVIER-SEQUOIA S.A. LAUSANNE, CH, Bd. 229, Nr. 1, 5. Juni 1993 (1993-06-05), Seiten 44-50, XP000370672 ISSN: 0040-6090

## Beschreibung

Die Erfindung betrifft eine Kompositstruktur für elektronische Mikrosysteme sowie ein Verfahren zur Herstellung der Kompositstruktur , wie beides aus der gattungsbildend zugrundegelegten DE 197 18 618 C2 als bekannt hervorgeht.

Aus der DE 197 18 618 C2 ist eine Kompositstruktur bekannt, bei der auf einem Wachstumssubstrat aus monokristallinem Silizium aufgebrachte mikroelektronische Bauteile wie Transistoren, Dioden, Widerstände, Kapazitäten, Induktivitäten usw., oder Schaltungen aus diesen'wie bspw. Verstärker, Sensoren, Emissionskathoden für Elektronen etc., mit einer Wärmeleitschicht aus Diamant versehen sind. Die Druckschrift offenbart auch eine diesbezügliche Plasma-CVD zum Aufbringen der Diamantschicht. Die Wärmeleitschicht besteht u.a. anderem deshalb aus Diamant, da dieses Material trotz einer elektrischen Isolation auch eine gute Wärmeleitfähigkeit aufweist. Daher ist eine derartige Wärmeleitschicht aus insbesondere poly-, kristallinem Diamant für ein thermisches Management von mikroelektronischen Bauteilen hervorragend geeignet.

Die Abscheidung der Diamantschicht auf den Bauteilen muss allerdings bei für eine Epitaxie tiefen Temperaturen erfolgen, damit die Bauteile nicht beeinträchtigt oder sogar zerstört werden.

Ferner muss die Diamantschicht trotz gegenüber den beschichteten Materialien unterschiedlicher Wärmeausdehnung eine gute Haftung auf der beschichteten Oberfläche aufweisen. Durch diese Rahmenbedingungen muss die Epitaxie der vorbekannten Wärmeleitschicht aus Diamant sehr sorgfältig vorgenommen werden.

Insbesondere ergeben sich bei Wachstumssubstraten und/oder Bauteilen, die binäre, ternäre, quarternäre oder noch höherwertigere Verbindungshalbleiter aufweisen dahingehend Schwierigkeiten, dass diese Materialien sehr stark mit dem wasserstoffhaltigen Plasma bei der Diamantauftragung reagieren und dadurch zerstört und/oder sogar gänzlich entfernt werden.

In der EP 0681 314 A2 wird die Herstellung einer Kompositstruktur beschrieben, bei der auf einem geeigneten einkristallinen Wachstumssubstrat, z.B. aus Si oder GaAs, mittels einer Zwischenschicht mit durchgehender Gitterstruktur eine kristallin geordnete, d.h. bezüglich des Substrates heteroepitaktische, Diamantschicht abgeschieden wird. Ziel ist eine strukturell hochgeordnete Diamantschicht, die für die Herstellung elektronischer Bauelemente auf Diamantbasis geeignet ist. Das Substrat dient dazu, orientiertes Diamantwachstum zu ermöglichen, und beinhaltet daher keinerlei elektronische Bauelemente. Für dieses Wachstum ist eine Gitterkonstante erforderlich, die derjenigen von Diamant möglichst ähnlich ist. Eine Gitterfehlanpassung soll dadurch reduziert werden, dass eine einkristalline Zwischenschicht mit einer Gitterkonstanten, die zwischen den Gitterkonstanten von Diamant und Substrat liegt, verwendet wird.

Die Druckschrift FR 2 734 663 A beschreibt eine Kompositstruktur für elektronische Bauelemente mit einem Vertiefungen aufweisenden Grundsubstrat und mit einer Deckschicht, die auf der durch die Vertiefung strukturierten Flachseite angeordnet ist und die Vertiefung unter Ausbildung einer Hohlstruktur bedeckt. Bei dieser Kompositstruktur besteht die Deckschicht aus polykristallinem Diamant mit statistischer Orientierung der Netzebenen der Kristallite. So wird eine Zwischenschicht erläutert, die in Form einer Spenderschicht angeordnet ist. Die Materialien der hoch dotierten Spenderschicht, insbesondere n-dotiertes kubisches Bornitrid in der Bodenschicht, auf die sie aufgebracht wird, sind hierbei derart abgestimmt, dass deren Bandkantenverlauf im Bereich der Grenzfläche zwischen der Spenderschicht und der Bodenschicht eine Banddiskontinuität audbildet. Auf diese Weise können ohne äußere Beeinflussung Ladungsträger der Spenderschicht in die Bodenschicht abfließen. Die Zwischenschicht kann je nach gewünschtem elektronischem Bauelement, beispielweise aus magnetischem, aus isolierendem und/oder aus metallischem Werkstoff gebildet sein.

Die Druckschrift EP 0 681 336 A2, die als nächsteliegender Stand der Technik angesehen wird, beschreibt eine Halbleiterkompositstruktur für ein elektronisches Bauteil, die eine, abgesehen von unvermeidbaren Verunreinigungen, im Wesentlich undotierte kristalline Diamantschicht aufweist. Diese Diamantschicht wird durch eine Zwischenschicht von einer Halbleiterschicht getrennt. Die wesentliche Aufgabe der Zwischenschicht ist es, in einfacher Weise eine direkte oder eine modifizierte Gitteranpassung zwischen der Halbleiterschicht und der kristallinen Diamantschicht zu realisieren. Diese Zwischenschicht kann eine Legierung sein, die über ein kristallografisch regelmäßiges, ein Diamant-, eine Kalziumfluorid-, oder eine Zinkblendestruktur aufweisendes Legierungsgitter verfügt. Die Zusammensetzung der Legierung verändert sich mit zunehemendem Abstand von der Halbleiterschicht.

Aufgabe der vorliegenden Erfindung ist es, eine Kompositstruktur für mikroelektronische Bauteile sowie ein Verfahren zu Herstellung zu entwickeln, die zumindest weitgehend die bereits bekannten Vorteile einer Wärmeleitschicht aus Diamant aufweist.

Die Aufgabe wird erfindungsgemäß mit einer Kompositstruktur mit den Merkmalen des Anspruchs 8 bzw. mit einem Verfahren mit den Verfarensschritten des Anspruchs 1 gelöst. Durch die erfindungsgemäße Verwendung und CVD-Abscheidung von den in Anspruch 1 und Anspruch 2 anhand ihres chemischen Reaktionsvermögens definierten Substanzen in ausreichender Dicke, gelangen Komponenten das wasserstoffhaltigen Plasma nicht mehr an die Verbindungshalbleiter der Komponentenschicht.

Die Komponentenschicht der vorliegenden Kompositstruktur enthält elektronische Mikrosysteme wie bspw. ICs, Halbleiterlaser, Sensoren, Transistoren, Dioden usw. und/oder daraus hergestellte Bauteile wie Verstärker, Sensoren, Emissionskathoden für Elektronen etc.

Zweckmäßigerweise werden auch metallene Funktionsschichten wie Leiterbahnen usw., die zumindest teilweise nicht von der Diamantschicht bedeckt werden sollten, mit einer Schutzschicht versehen.

Als Materialien für die Schutzschicht haben sich je nach Anwendungsfall bzw. vor dem Hintergrund der zu schützenden Materialien Nitride und/oder Oxide und/oder Carbide und/oder Oxynitride und/oder diamantähnlicher Kohlenstoff, besonders Siliziumnitrid, bevorzugt Si₃N₄, und/oder Siliziumoxid, bevorzugt SiO₂, und/oder Siliziumcarbid, bevorzugt SiC, und/oder Siliziumoxynitride als sinnvoll erwiesen. Des Weiteren ist auch Aluminiumnitrid, bevorzugt AlN, und/oder Aluminiumoxid, bevorzugt Al₂O₃, geeignet. Die Schutzschicht kann hierbei einkristallin, poykristallin (z.B. aus nicht stöchiometrischem Si-Nitrid) oder auch amorph (z.B. aus diamantähnlichem Kohlenstoff) sein.

Damit die Funktion der Schutzschicht sicher gewährleistet ist, wird deren Schichtdicke so gewählt, dass sie während des gesamten Abscheideprozesses der Diamantschicht in zusammenhängender Weise geschlossen erhalten bleibt. Dies gilt insbesondere selbst bei einer Selbstverzehrung durch die Komponenten des Plasmas, bei der dann die Schutzschicht zwar mit reduzierter Schichtdicke aber dennoch zusammenhängend geschlossen erhalten bleiben sollte; d.h. die Schutzschicht muss die betreffenden Materialien zumindest so lange einschließen, bis eine geschlossene Diamantschicht abgeschieden ist. Trotz der Anordnung von derartigen Schutzschichten, die sich aufgrund ihrer geringeren Wärmeleitfähigkeit in nachteiliger Weise auf die Wärmeabfuhr der Diamantschicht auswirken können, ist die Wärmeabfuhr bei erfindungsgemäßen Komposit-Strukturen aufgrund der nach Abscheidung der Diamantschicht verbleibenden geringen Dicke der Schutzschichten immer noch ausreichend.

Die Güte des zur Wärmeableitung auf die Komponentenschicht aufgebrachten Schichtsystems aus Diamantschicht und Zwischenschicht wird durch den Gütefaktor angegeben. Der Gütefaktor der thermischen Massnahme entspricht dem Verhältnis von Temperaturhub ohne die thermische Massnahme, d.h. ohne das Schichtsystem, zum Temperaturhub mit dem Schichtsystem. Als Temperaturhub wird hierbei die Differenz aus der Spitzentemperatur in der Komponentenschicht, die beim bestimmungsgemäßen Betrieb der darin integrierten elektronischen Bauelemente und Schaltungen erreicht wird, und der Umgebungstemperatur bezeichnet. Vorzugsweise werden beim vorliegenden Verfahren die Schichtdicken von Diamantschicht und Zwischenschicht so bemessen, dass die fertig gestellte Kompositstruktur einen Gütefaktor von 1,5 oder darüber aufweist. Dieser Gütefaktor hängt unter anderem von der Dicke der Zwischenschicht ab. Bei vorgegebener Dicke der Diamantschicht muss die Dicke der Zwischenschicht daher bei der Abscheidung so bemessen werden, dass nach dem Aufbringen der Diamantschicht die obige Bedingung erreicht wird, d. h. die Zwischenschicht sollte in der fertig gestellten Kompositstruktur eine bestimmte Dicke nicht überschreiten. Diese maximale Dicke hängt von der Wärmeleitfähigkeit der Zwischenschicht ab. Wird das schlecht wärmeleitfähige Siliciumnitrid als zwischenschicht verwendet, so sollte die Dicke nicht größer als 20 nm sein. Bei AlN als Zwischenschicht sind 200 nm tolerabel.

Idealerweise wird die Dicke der Zwischenschicht vor dem Aufbringen der Diamantschicht so gewählt, dass sie - insbesondere bei schlechter Wärmeleitfähigkeit - nach dem Aufbringen der Diamantschicht nur noch wenige Atomlagen dick ist.

Weitere zweckmäßige Ausgestaltungen der Erfindung sind den entsprechenden Unteransprüchen entnehmbar. Im Übrigen wird die Erfindung anhand von in den Figuren dargestellten Ausführungsbeispielen erläutert. Dabei zeigt
- Fig. 1: eine 100-fache Vergrößerung einer Bruchkante eines unbeschichteten InP-Wachstumssubstrats;
- Fig. 2: eine 10.000-fache Vergrößerung eines mit einer Schutz- und einer Diamantschicht versehenen InP-Wachstumssubstrats;
- Fig. 3: eine 20.000-fache Vergrößerung der Oberfläche der Komposit-Struktur nach Figur 2;
- Fig. 4: eine 20.000-fache Vergrößerung eines mit einer Schutz- und einer Diamantschicht versehenen GaAs-Wachstumssubstrats;
- Fig. 5: eine 20.000-fache Vergrößerung der Oberfläche der Komposit-Struktur nach Figur 4; und
- Fig. 6: schematisch einzelne Verfahrensschritte zur Herstellung der vorliegenden Kompositstruktur.

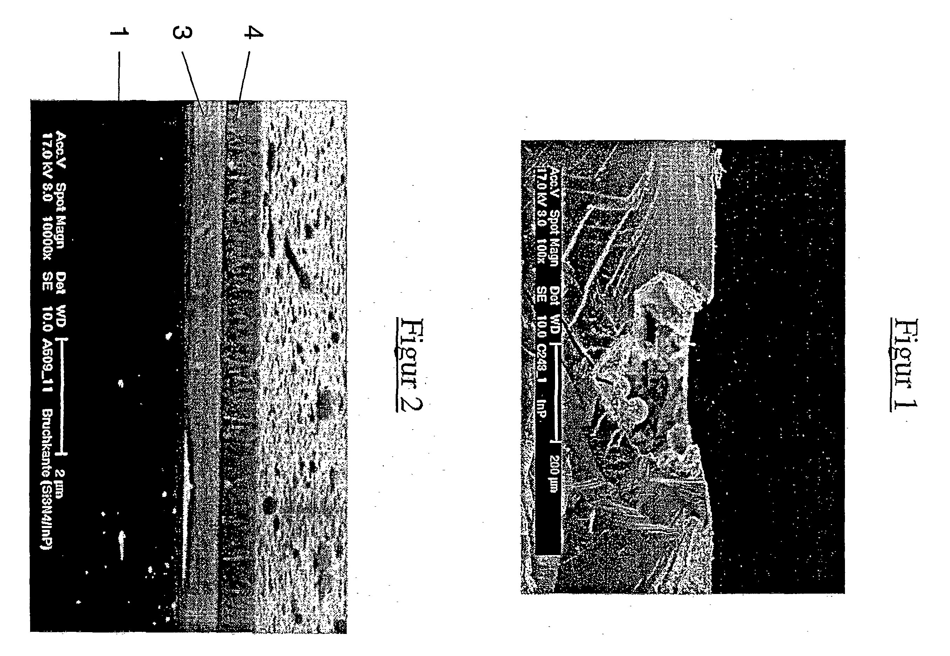

In Figur 1 ist eine 100-fache Vergrößerung einer Bruchkante eines unbeschichteten InP-Wachstumssubstrats dargestellt, das nur wenige Sekunden Prozessbedingungen ausgesetzt war, wie sie bei der Abscheidung von Diamant mittels einer BIAS-unterstützten Plama-CVD auftreten. Hierbei wird ersichtlich, wie das InP-Wachstumssubstrat sehr stark in Mitleidenschaft gezogen ist. Diesbezügliche Versuche haben ergeben, dass ein InP-Substrat herkömmlicher Schichtdicke innerhalb nur weniger Minuten vollständig durchgeätzt ist.

In Figur 2 ist eine 10.000-fache Vergrößerung einer Bruchkante eines beschichteten InP-Wachstumssubstrats 1 dargestellt, das zuerst mit einer Schutzschicht aus Si₃N₄ 3 und anschließend mit der polykristallinen Diamantschicht 4 beschichtet wurde. Anhand einer Untersuchung wurde herausgefunden, dass die Schichtdicke der Schutzschicht 3 vor Beginn der Abscheidung der Diamantschicht wenigstens 20 nm, bevorzugt mindestens 50 nm und besonders bevorzugt mindestens 100 nm betragen sollte.

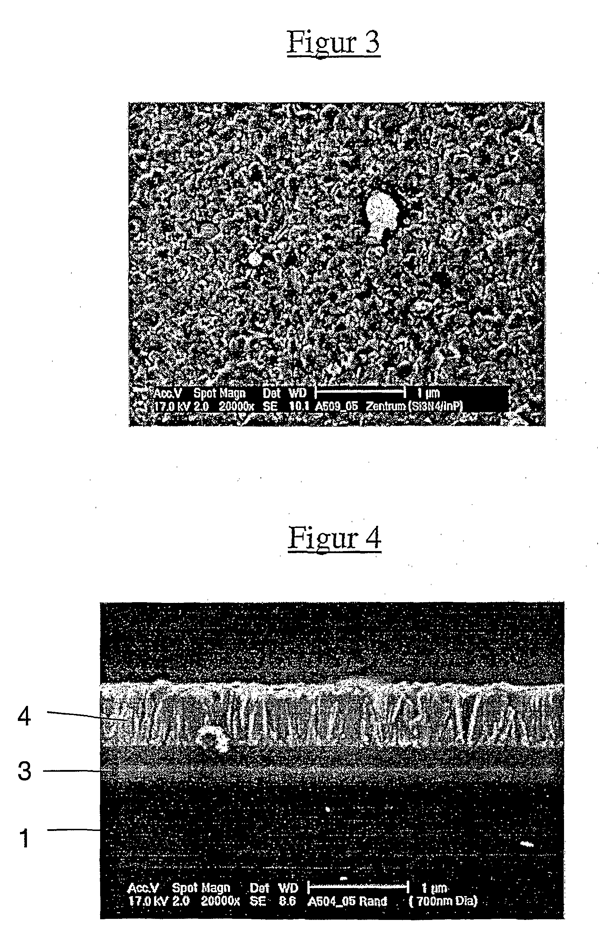

In Figur 3 ist eine 1:20.000-fache Vergrößerung der Diamantoberfläche der Kompositstruktur nach Figur 2 dargestellt. In diesem Bild lässt sich insbesondere der polykristalline Charakter der Diamantschicht erkennen.

In Figur 4 ist eine 20.000-fache Vergrößerung einer Bruchkante eines beschichteten GaAs-Wachstumssubstrats 1 dargestellt. Das GaAs-Wachstumssubstrat 1 wurde zuerst mit einer Schutzschicht 3 aus Si₃N₄ und anschließend mit der polykristallinen Diamantschicht 4 beschichtet. Auch hat sich gezeigt, dass die Schichtdicke der Schutzschicht 3 vor Beginn der Abscheidung der Diamantschicht 4 wenigstens 20 nm, bevorzugt mindestens 50 nm und besonders bevorzugt mindestens 100 nm betragen sollte.

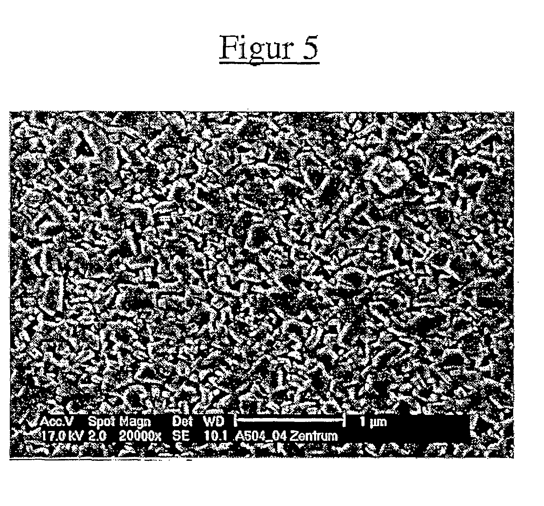

In Figur 5 ist eine 1:20.000-fache Vergrößerung der Diamantoberfläche der Kompositstruktur nach Figur 4 dargestellt. Auch in diesem Bild lässt sich insbesondere der polykristalline Charakter der Diamantschicht erkennen.

Die Schutz- und die Diamantschicht wurden jeweils mittels einem bekannten EIAS unterstützen Plasma-CVD-Verfahren hergestellt. Die hierbei verwendeten Prozessparameter sind in der nachfolgenden Tabelle aufgelistet.

| | |
|---|---|
| DC-power | 2.7 kW |
| Substrattemp. | 180 - 360°C |
| Druck | 10.0 - 14.6 slm |
| Gasfluss | 0.5 mbar |
| Kohlenstoffquellen | CH₄, C₂H₄ |
| Verhältnis C/H | 0.15 - 0.3 % |
| Verhältnis O/C | 30 - 100 % |

Einzelheiten zu einem Verfahren der Abscheidung einer Diamantschicht können beispielsweise der Veröffentlichung von M. Seelmann-Eggebert et al., "Heat-spreading diamond films for GaN-based high-power transistor devices", Diamond and Related Materials 10, 2001, S. 744 - 749, entnommen werden, deren Offenbarungsgehalt in die vorliegende Beschreibung einbezogen wird.

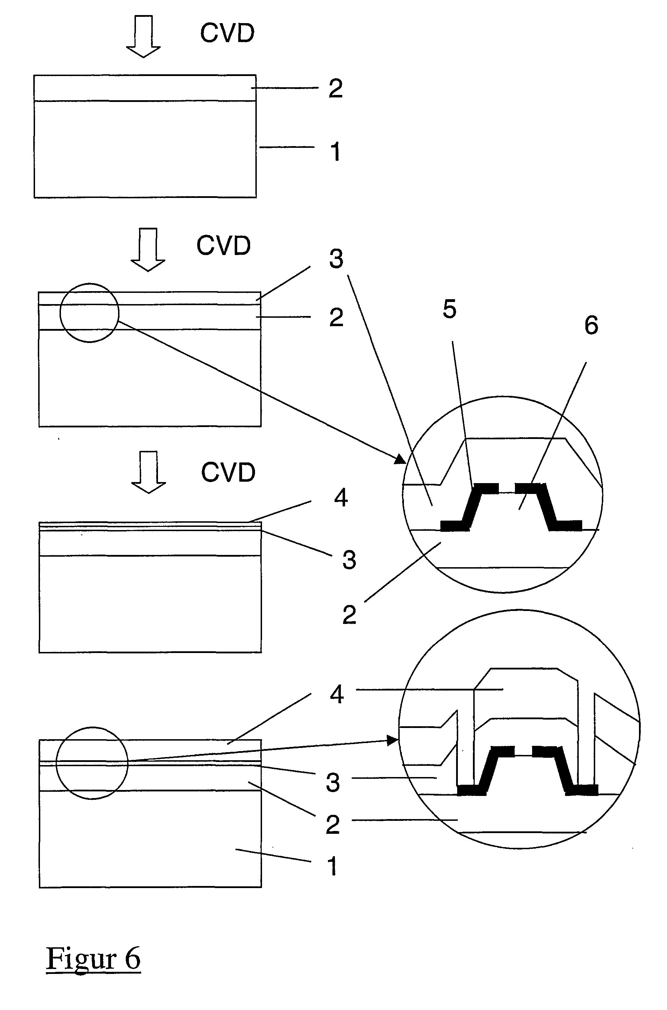

Fig. 6 zeigt schematisch einzelne Verfahrensschritte zur Herstellung der vorliegenden Kompositstruktur. Zunächst wird ein Wachstumssubstrat 1 bereitgestellt, das eine Komponentenschicht mit den elektronischen Mikrosystemen aufweist (Fig. 6a). Die Komponentenschicht 2 kann beispielsweise aus GaN, das Wachstumssubstrat aus Saphir gebildet sein. Auf die Komponentenschicht 2 wird im nächsten Schritt eine Schutzschicht 3 aus Si₃N₄ aufgebracht, die die Komponentenschicht 2 vollständig umschließt (Fig. 6b). In der Ausschnittsvergrößerung im rechten Teil der Figur ist hierbei beispielhaft eine Bauelement 6 dieser Komponentenschicht 2 mit der zugehörigen Anschlussmetallisierung 5 zu erkennen. Anschließend wird auf die Schutzschicht 3 mittels Plasma-CVD eine polykristalline Diamantschicht abgeschieden. Während des ersten Zeitraums dieser Abscheidung - noch bevor eine ganzflächige dünne Diamantschicht vorliegt - wird die Schutzschicht 3 durch das Plasma bei der Diamantauftragung angegriffen und gegebenenfalls in der Schichtdicke reduziert. Nachdem eine vollflächige dünne Diamantschicht abgeschieden ist, stoppt diese Abtragung (Fig. 6c), die in der Figur übertrieben dargestellt ist. Der Abscheideprozess der Diamantschicht wird bis zur gewünschten Schichtdicke fortgesetzt (Fig. 6d).

Bei der Diamantabscheidung wird durch Einsatz einer Maske, beispielsweise mit Hilfe eines strukturierten Photoresists, sichergestellt, dass Bereiche der Anschlussmetallisierung 5 nicht von der Diamantschicht bedeckt werden. In diesen Bereichen wird anschießend auch die Schutzschicht 3 entfernt, so dass sie für eine externe Kontaktierung zugänglich sind (vgl. Ausschnittsvergrößerung der Fig. 6d).

## Patentansprüche

1. Verfahren zur Herstellung einer Kompositstruktur für elektronische Mikrosysteme, bei dem
- für die Kompositstruktur ein Wachstumssubstrat (1) bereitgestellt wird, das eine Komponentenschicht (2) mit den elektronischen Mikrosystemen enthält, wobei die Komponentenschicht (2) binäre oder höherkomponentige Verbindungshalbleiter enthält;
- auf die Komponentenschicht (2) eine Schutzschicht (3) aufgebracht wird, die die Komponentenschicht (2) zumindest mittelbar vollständig umschließt; und
- auf die Schutzschicht (3) mittels CVD, bevorzugt mittels Plasma-CVD, eine polykristalline Diamantschicht (4) zur Wärmeableitung aufgebracht wird; wobei für die Schutzschicht (3) ein Material gewählt wird, dessen chemisches Reaktionsvermögen gegenüber den bei der mittels CVD, bevorzugt mittels Plasma-CVD, vorgenommenen Abscheidung der Diamantschicht (4) vorliegenden Precursormaterialien kleiner als das der Komponentenschicht (2) ist, und die Schutzschicht (3) mit einer ursprünglichen Schichtdicke von mindestens 20 nm, bevorzugt mindestens 50 nm und besonders bevorzugt mindestens 100 nm aufgebracht wird.

2. Verfahren nach Anspruch 1,
**dadurch gekennzeichnet,**
**dass** für die Schutzschicht (3) Nitride und/oder Oxide und/oder Carbide und/oder Oxynitride und/oder diamantähnlichen Kohlenstoff gewählt werden.

3. Verfahren nach Anspruch 1,
**dadurch gekennzeichnet,**
**dass** für die Schutzschicht (3) Siliziumnitrid, bevorzugt Si₃N₄, und/oder Siliziumoxid, bevorzugt SiO₂, und/oder Siliziumcarbid, bevorzugt SiC, und/oder Siliziumoxynitride gewählt werden.

4. Verfahren nach Anspruch 1,
**dadurch gekennzeichnet,**
**dass** für die Schutzschicht (3) Aluminiumnitrid, bevorzugt AlN, und/oder Aluminiumoxid, bevorzugt Al₂O₃, gewählt wird.

5. Verfahren nach Anspruch 1,
**dadurch gekennzeichnet,**
**dass** zumindest einige metallene Funktionsschichten, insbesondere Leiterbahnen, zumindest bereichsweise innerhalb der Diamantschicht (4) angeordnet und/oder von dieser zumindest bereichsweise bedeckt werden.

6. Verfahren nach einem der Ansprüche 1 bis 5,
**dadurch gekennzeichnet,**
**dass** alle mit dem Precursormaterial der Diamantschicht (4) in Berührung kommenden Oberflächenbereiche der Komponentenschicht (2) mit der Schutzschicht (3) bedeckt werden.

7. Verfahren nach einem der Ansprüche 1 bis 6,
**dadurch gekennzeichnet,**
**dass** die Schichtdicke der Schutzschicht (3) so gewählt wird, dass sie nach Aufbringen der Diamantschicht (4) einen Wert hat, mit dem ein thermischer Gütefaktor der Diamant- und Schutzschicht (3, 4) von 1,5 oder darüber erreicht wird.

8. Kompositstruktur für elektronische Mikrosysteme, aus einem Wachstumssubstrat (1), das eine Komponentenschicht (2) mit den elektronischen Mikrosystemen enthält, und einer polykristallinen Diamantschicht (4) zur Wärmeableitung,
**dadurch gekennzeichnet,**
**dass** die Komponentenschicht (2) binäre oder höherkomponentige Verbindungshalbleiter enthält, dass zwischen der Komponentenschicht (2) und der Diamantschicht (4) eine Schutzschicht (3) angeordnet ist, die die Komponentenschicht (2) zumindest mittelbar vollständig umgibt, und
**dass** das chemische Reaktionsvermögen der Schutzschicht (3) gegenüber den bei der mittels CVD, bevorzugt mittels Plasma-CVD vorgenommenen Abscheidung der Diamantschicht (4) vorliegenden Precursormaterialien, kleiner ist als das entsprechende chemische Reaktionsvermögen der Komponentenschicht (2).

9. Kompositstruktur nach Anspruch 8,
**dadurch gekennzeichnet,**
**dass** die Schutzschicht (3) Nitride und/oder Oxide und/oder Carbide und/oder Oxynitride und/oder diamantähnlichen Kohlenstoff aufweist.

10. Kompositstruktur nach Anspruch 8,
**dadurch gekennzeichnet,**
**dass** die Schutzschicht (3) Siliziumnitrid, bevorzugt Si₃N₄, und/oder Siliziumoxid, bevorzugt SiO₂, und/oder Siliziumcarbid, bevorzugt SiC, und/oder Siliziumoxynitride aufweist.

11. Kompositstruktur nach Anspruch 8,
**dadurch gekennzeichnet,**
**dass** die Schutzschicht (3) Aluminiumnitrid, bevorzugt AlN, und/oder Aluminiumoxid, bevorzugt Al₂O₃, aufweist.

12. Kompositstruktur nach Anspruch 8,
**dadurch gekennzeichnet,**
**dass** zumindest einige metallene Funktionsschichten, insbesondere Leiterbahnen, zumindest bereichsweise innerhalb der Diamantschicht (4) angeordnet und/oder von dieser zumindest bereichsweise bedeckt sind.

13. Kompositstruktur nach Anspruch 8,
**dadurch gekennzeichnet,**
**dass** alle mit dem Precursormaterial der Diamantschicht (4) in Berührung kommenden Oberflächenbereiche der Komponentenschicht (2) mit der Schutzschicht (3) bedeckt sind.

14. Kompositstruktur nach einem der Ansprüche 8 bis 13,
**dadurch gekennzeichnet,**
**dass** die Schichtdicke der Schutzschicht (3) einen Wert hat, mit dem ein thermischer Gütefaktor der Diamant- und Schutzschicht (3, 4.) von 1,5 oder darüber erreicht wird.

## Claims

1. A method for producing a composite structure for electronic microsystems, in which
- a growth substrate (1), which contains a component layer (2) with said electronic microsystems, is provided for said composite structure, with said component layer (2) containing binary or higher order compound semiconductors;
- a protective layer (3), which encloses said component layer (2) at least indirectly completely, is applied onto said component layer (2); and
- a polycrystalline diamond layer (4) for heat withdrawal is applied onto said protective layer (3) by means of CVD, preferably by means of plasma CVD; with a material being selected for said protective layer (3), whose chemical reactivity with the precursor materials present in the deposition of said diamond layer (4) by means of CVD, preferably by means of plasma CVD, is lower than that of the component layer (2), and said protective layer (3) is applied with an original layer thickness of at least 20 nm, preferably at least 50 nm and particularly preferred at least 100 nm.

2. A method according to claim 1,
**characterized in that** nitrides and/or oxides and/or carbides and/or oxynitrides and/or diamond-like carbon are selected for said protective layer (3).

3. A method according to claim 1,
**characterized in that** silicon nitride, preferably Si₃N₄ , and/or silicon oxide, preferably SiO₂ , and/or silicon carbide, preferably SiC, and/or silicon oxynitrides are selected for said protective layer (3).

4. A method according to claim 1,
**characterized in that** aluminum nitride, preferably AlN, and/or aluminum oxide, preferably Al₂O₃ are selected for said protective layer (3).

5. A method according to claim 1,
**characterized in that** at least a plurality of metallic function layers, in particular strip conductors are at least disposed regionwise within said diamond layer (4) and/or at least covered regionwise thereby.

6. A method according to one of the claims 1 to 5,
**characterized in that** all the surface regions of said component layer (2) which come into contact with the precursor material of said diamond layer (4) are covered with said protective layer (3).

7. A method according to one of the claims 1 to 6,
**characterized in that** the layer thickness of said protective layer (3) is selected in such a manner that after application of said diamond layer (4) it has a value with which a thermal quality factor of said diamond and protective layer (3,4) of 1.5 or more is yielded.

8. A composite structure for electronic microsystems, comprising a growth substrate (1), which contains a component layer (2) with said electronic microsytems, and a polycrystalline diamond layer (4) for withdrawal of heat,
**characterized in that** said component layer (2) contains binary or higher order compound semiconductors, a protective layer (3), which encloses said component layer (2) at least indirectly completely, is disposed between said component layer (2) and said diamond layer (4), and the chemical reactivity of said protective layer (3) with the precursor materials present during deposition of the diamond layer (4) by means of CVD, preferably plasma CVD, is lower than the corresponding chemical reactivity of said component layer (2).

9. A composite structure according to claim 8, **characterized in that** said protective layer (3) comprises nitrides and/or oxides and/or carbides and/or oxynitrides and/or diamond-like carbon.

10. A composite structure according to claim 8,
**characterized in that** said protective layer (3) comprises silicon nitride, preferably Si₃N₄, and/or silicon oxide, preferably SiO₂ , and/or silicon carbide, preferably SiC, and/or silicon oxynitrides.

11. A composite structure according to claim 8,
**characterized in that** said protective layer (3) comprises aluminum nitride, preferably AlN, and/or aluminum oxide, preferably Al₂O₃.

12. A composite structure according to claim 8,
**characterized in that** at least a plurality of metallic function layers, in particular strip conductors are at least disposed regionwise within said diamond layer (4) and/or at least are covered regionwise thereby.

13. A composite structure according to claims 8,
**characterized in that** all the surface regions of said component layer (2) which come into contact with the precursor material of said diamond layer (4) are covered with said protective layer (3).

14. A composite structure according to one of the claims 8 to 13, **characterized in that** the layer thickness of said protective layer (3) has a value with which a thermal quality factor of said diamond and protective layer (3,4) of 1.5 or more is achieved.

## Revendications

1. Procédé de fabrication d'une structure composite pour microsystèmes électroniques, dans lequel
- le substrat de croissance (1) est rendu disponible pour la structure composite, qui contient une couche à composants (2) auxdits microsystèmes électronique, ladite couche à composants (2) contenant des semi-conducteurs de connexion binaires ou aux composants d'un plus haut ordre;
- une couche de protection (3) est appliquée sur la couche aux composants (2), qui entoure ladite couche à composants (2) complètement, au moins indirectement; et une couche (4) en diamant polycristallin est déposée sur ladite couche de protection (3) pour la dissipation thermique, moyennant un processus CVD, de préférence moyennant un processus de plasma CVD;
dans lequel un matériau set choisi pour ladite couche de protection (3), dont la réactivité chimique vis-à-vis les matériaux précurseurs présent au dépôt de ladite couche en diamant (4), qui est réalisé moyennant un processus CVD, de préférence un processus à plasma CVD, est réduite relativement à la réactivité de la couche à composants (2), et
dans lequel ladite couche de protection (3) est déposée à une épaisseur de couche originale d'au moins 20 nm, de préférence d'au moins 50 nm, et particulièrement de préférence d'au moins 100 nm.

2. Procédé selon la revendication 1,
**caractérisé en ce**
**que** des nitrures et/ou oxydes et/ou carbures et/ou oxynitrures et/ou du charbon similaire au diamant sont choisis pour la couche de protection (3).

3. Procédé selon la revendication 1,
**caractérisé en ce**
**que** de nitrure de silicium, de préférence Si₃N₄, et/ou de l'oxyde de silicium, de préférence SiO₂, et/ou de carbure de silicium, de préférence SiC, et/ou des oxynitrures de silicium sont choisis pour ladite couche de protection (3).

4. Procédé selon la revendication 1,
**caractérisé en ce**
**que** de nitrure d'aluminium, de préférence AlN, et de l'oxyde d'aluminium, de préférence Al₂O₃, est choisi pour ladite couche de protection (3).

5. Procédé selon la revendication 1,
**caractérisé en ce**
**qu'**au moins quelques couches fonctionnelles métalliques, en particulier des pistes conductrices, sont disposées, au moins dans quelques zones, à l'intérieur de ladite couche en diamant (4) et/ou sont couvert par la dernière, au moins dans quelques zones.

6. Procédé selon une quelconque des revendications 1 à 5,
**caractérisé en ce**
**que** toutes les zones superficielles de ladite couche à composants (2), qui sont portées en contact avec le matériau précurseur de ladite couche en diamant (4), sont couvert par ladite couche de protection (3).

7. Procédé selon une quelconque des revendications 1 à 6,
**caractérisé en ce**
**que** l'épaisseur de couche de ladite couche de protection (3) est choisie d'une telle manière, qu'elle a une valeur, après le dépôt de ladite couche en diamant (4), auquel on achève un facteur de qualité thermique de ladite couche en diamant de ladite couche de protection (3, 4) de 1,5 ou plus.

8. Structure composite pour microsystèmes électroniques, fabriquée d'un substrat de croissance (1), qui contient une couche à composants (2) aux microsystèmes électroniques, et une couche en diamant (4) pour la dissipation de la chaleur,
**caractérisée en ce**
**que** ladite couche à composants (2) contient des semi-conducteurs de connexion binaires ou aux composants d'un plus haut ordre,
en ce qu'une couche de protection (3) est disposée entre ladite couche à composants (2) et ladite couche en diamant, qui entoure ladite couche à composants (2) complètement, au moins indirectement, et
en ce que la réactivité chimique de ladite couche de protection (3) vis-à-vis les matériaux précurseurs, qui sont présents au cours du dépôt de ladite couche en diamant (4), qui est réalisé moyennant un processus CVD, de préférence un processus de plasma CVD, est réduite relativement à la réactivité chimique correspondante de ladite couche à composants (2).

9. Structure composite selon la revendication 8,
**caractérisée en ce**
**que** ladite couche de protection (3) contient des nitrures et/ou des oxydes et/ou des carbures et/ou des oxynitrures et/ou du charbon similaire au diamant.

10. Structure composite selon la revendication 8,
**caractérisée en ce**
**que** ladite couche de protection (3) contient de nitrure de silicium, de préférence Si₃N₄, et de l'oxyde de silicium, de préférence SiO₂, et/ou de carbure de silicium, de préférence SiC, et/ou des oxynitrures de silicium.

11. Structure composite selon la revendication 8,
**caractérisée en ce**
**que** ladite couche de protection (3) contient de nitrure d'aluminium, de préférence AlN, et/ou de l'oxyde d'aluminium, de préférence Al₂O₃.

12. Structure composite selon la revendication 8,
**caractérisée en ce**
**qu'**au moins quelques couches fonctionnelles métalliques, en particulier des pistes électroconductrices, sont disposées, au moins dans quelques zones, à l'intérieur de ladite couche en diamant (4) et/ou sont couvert par la dernière, au moins en quelques zones.

13. Structure composite selon la revendication 8,
**caractérisée en ce**
**que** toutes les zones superficielles de ladite couche à composants (2), qui entrent en contact avec le matériau précurseur de ladite couche en diamant (4), sont couvert par ladite couche de protection (3).

14. Structure composite selon une quelconque des revendications 8 à 13,
**caractérisée en ce**
**que** l'épaisseur de couche de ladite couche de protection (3) a une valeur, à laquelle un facteur de qualité thermique de 1,5 ou plus de ladite couche en diamant et ladite couche de protection (3, 4) est achevé.
